# EUROPÄISCHE PATENTSCHRIFT

(11) **EP 2 194 162 B1**
(45) Veröffentlichungstag und Bekanntmachung des Hinweises auf die Patenterteilung: **15.10.2014**
(21) Anmeldenummer: 09178044.5
(22) Anmeldetag: 04.12.2009
(51) Int. Cl.: C23C 16/513, C23C 16/40

(54) **Verwendung einer Schicht**
Use of a coating
Utilisation d'une couche

(30) Priorität: 06.12.2008 DE 102008060923
(43) Veröffentlichungstag der Anmeldung: 09.06.2010
(73) Patentinhaber: Innovent e.V., 07745 Jena (DE)
(72) Erfinder: Schimanski, Arnd, 99085 Erfurt (DE); Grünler, Bernd, 07937 Zeulenroda (DE); Pfuch, Andreas, 99510 Apolda (DE); Heft, Andreas, 07545 Gera (DE); Polster, Martin, 07952 Pausa (DE)
(74) Vertreter: Liedtke, Markus

(56) Entgegenhaltungen:
- DE-A1-102007 025 151
- DE-A1-102007 025 152

## Beschreibung

Die Erfindung betrifft die Verwendung einer Schicht auf einer Oberfläche eines Substrats, hergestellt nach einem Verfahren zur Beschichtung eines Substrats.

Die meisten technisch genutzten metallischen Werkstoffe müssen auf Grund ihrer Stellung in der elektrochemischen Spannungsreihe vor Korrosion geschützt werden. Die technisch wichtigsten Werkstoffe sind dabei die Eisenlegierungen; aber auch Legierungen des Aluminiums besitzen eine hohe Bedeutung. Bislang wurden diese Materialien mit Hilfe der Chromatierung behandelt, um diese vor Korrosion zu schützen. Die gesetzlichen Verordnungen zum Ersatz der Chrom IV-haltigen Beschichtungen haben den Einsatz von alternativen Verfahren gefördert. Ein häufig verwendetes Verfahren zur Erhöhung der Korrosionsfestigkeit ist das Phosphatieren, ein nasschemischer Prozess. Dabei werden die metallischen Werkstücke in der Regel in Metallphosphatlösungen bzw. phosphorsaure Lösungen getaucht. Hierbei wird ein Teil der ursprünglichen Metalloberfläche aufgelöst und an deren Stelle scheidet sich eine schwerlösliche Metallphosphatschicht ab, welche einen höheren Korrosionsschutz als die ursprüngliche Oberfläche bietet und auch als Haftschicht für weitere Oberflächenüberzüge wie Lacke dienen kann (R. Hoffmann: Chemie für die Galvanotechnik, Lehrbuchreihe Galvanotechnik 1993).

Auch Glaswerkstoffe bzw. funktionale Schichtsysteme auf Glas müssen oft mit einer vor Korrosion oder mechanischer Beschädigung schützenden Schicht versehen werden. Als Materialien für solche Schichten haben sich Siliziumnitrid, Siliziumdioxid bzw. Oxynitride bewährt. Solche Schichten werden in der Regel durch PVD-Verfahren (physical vapor deposition) wie Bedampf- und Zerstäubungsprozesse aufgebracht. Meist werden die Schichten durch Festkörperzerstäubung (Sputtern) aufgebracht. Dabei wird das abzuscheidende Material durch Beschuss mit hochenergetischen Ionen inerter Gase (Edelgase) oder Ionen reaktiver Gase (Sauerstoff, Stickstoff) aus den Targets herausgeschlagen und auf dem Substrat abgeschieden. Hierzu existiert eine umfangreiche Standardliteratur (z.B. K.Wasa, S. Hayakawa: "Handbook of Sputter Deposition Technology", Materials Science and Process Technology Series, 1992).

In EP 0 857 700, US 6,114,043, DE 69 813 648 erfolgt die Abscheidung einer dünnen Schicht aus Siliziumnitrid oder Oxynitrid durch CVD (chemical vapor deposition). Dabei wird die Schicht aus der Gasphase bei Substrattemperaturen von 550°-760°C abgeschieden. Um die erforderlichen hohen Substrattemperaturen zu erreichen, wird der Prozess bevorzugt in die Glasherstellung am Floatband integriert. Als Additive können Phosphor, Bor und Fluor zugefügt werden wobei entsprechende Aminverbindungen besondere Bedeutung als Vorläufer (Precursor) für die Herstellung der Nitride bzw. Oxynitride besitzen.

Bei anderen bekannten Verfahren werden metallorganische Verbindungen in eine Knallgas- oder Brennerflamme eingebracht, dabei zersetzt und auf einer begrenzten Oberfläche abgeschieden. Diese Verfahren werden als Flammenpyrolyse oder C-CVD (cumbustion-chemical vapor deposition) bezeichnet (US 4,600,390). In der Patenschrift DE 42 37 921 A1 wird die flammenpyrolytische Abscheidung von siliziumorganischen Verbindungen für die Aufbringung siliziumoxidhaltiger Schichten genutzt. Ziel dieser Beschichtungen ist die Erhöhung der Hydrophilie der Oberflächen und die Verwendung als Haftvermittlerschicht.

In der WO 93/12892 wird eine Abscheidung von Metalloxidfilmen bzw. Mischoxiden durch CVD-Prozesse bei Atmosphärendruck vorgeschlagen um amorphe Schichten mit bestimmten Brechungsindex, Farberhöhung, Abriebsfestigkeit oder selektive Lichtfilterung auf flachen Glassubstraten zu erzeugen. Dazu werden Precursoren für Metalloxide von Selen, Germanium, Titan, Aluminium, Zirkonium, Zinn, Indium, Cadmium, Hafnium, Wolfram, Vanadin, Chrom, Molybdän, Iridium, Nickel und Tantal sowie Precursor für SiO₂ verwendet. Weiterhin ist die Zugabe von Additiven wie PH₃, AsH₃, B₂H₆, O₂, N₂O NF₃, NO₂ und CO₂ zur Erhöhung der Abscheidungsrate der Filme beschrieben. Die Gasmischungen werden dabei bei Atmosphärendruck und unter 200°C auf die Substrate aufgebracht. Die Substrattemperaturen müssen allerdings zwischen 450°-650°C liegen.

Die WO 99/13129 beschreibt einen C-CVD-Prozess zur Abscheidung von Phosphatfilmen und -beschichtungen auf kleinflächigen Substraten. Diese Verfahren eignet sich zum Beschichten von Fasern aus Siliziumcarbid, Aluminiumoxid und anderen Metalloxiden und zur Stärkung deren Matrices. Die Phosphate, bevorzugt Metallphosphate, können als Korrosionsschutz und zur Einstellung des Brechungsindices verwendet werden. Im Prozess werden Flüssigkeiten oder Dämpfe, welche die zur Schichtbildung benötigten Reagenzien enthalten, mit einem oxidierenden Gas gemischt und verbrannt. Die Schichten werden durch die dabei gebildeten heißen Gase mit den verdampften Reagenzien abgeschieden. Die erhaltenen Schichten sind bevorzugt kristallin und oxidisch, wobei sowohl amorphe Schichten als auch die Abscheidung von Nitriden, Carbiden und Carbonaten beschrieben werden. Als Parameter für die Prozesse werden Flammentemperaturen von 300°-2800°C, Substrattemperaturen 100°-2200°C sowie ein Druckbereich Druck 10-10.000 Torr angegeben.

Aus DE 10 2007 025 151 A1 und aus DE 10 2007 025 152 A1 sind Beschichtung von Oberflächen von Substraten bekannt, bei denen mindestens ein Precurser in ein Arbeitsgas und/oder einen Plasmastrahl geleitet wird und unter Bildung eines Reaktionsproduktes umgesetzt wird.

Der Erfindung liegt die Aufgabe zu Grunde, eine verbesserte Verwendung einer Schicht auf einer Oberfläche eines Substrats, hergestellt nach einem Verfahren zur Beschichtung eines Substrats mit dem Ziel eines verbesserten Korrosionsschutzes anzugeben.

Die Aufgabe wird erfindungsgemäß gelöst durch ein Verfahren mit den Merkmalen des Anspruchs 1.

Vorteilhafte Ausgestaltungen der Erfindung sind Gegenstand der Unteransprüche.

Eine Schicht auf einer Oberfläche eines eisenhaltigen Substrats, welche mittels eines Verfahrens zur Beschichtung eines Substrats aufgetragen wurde, wird erfindungsgemäß zum Korrosionsschutz des Substrates verwendet. Zur Herstellung der Schicht wird mindestens ein Precursor einem Arbeitsgas und/oder einem Plasmastrahl und/oder einer Flamme zugeführt und im Plasmastrahl oder in der Flamme zur Reaktion gebracht. Dabei umfasst einer der Precursoren Silizium oder eine Siliziumverbindung. Ebenso umfasst einer der Precursoren Phosphor oder eine Phosphorverbindung. Hierdurch werden Silizium und Phosphor enthaltende Reaktionsprodukte auf einer Oberfläche des Substrats in mindestens einer Schicht abgeschieden. Auf einfache Weise bildet sich dabei eine Mischschicht mit einem so genannten ternären System aus, das Phosphor, Silizium und Sauerstoff enthält. Der Phosphor bindet sich überraschender Weise besonders gut an die Oberfläche, wenn ebenfalls Silizium abgeschieden wird, welches die Haftvermittlung verbessert. Dadurch wird ein besonders effektiver Korrosionsschutz ermöglicht.

Wenn das Substrat Eisen enthält, bindet sich der Phosphor besonders gut an das Eisen, wenn ebenfalls Silizium abgeschieden wird.

Im Gegensatz zu nasschemischen Beschichtungstechnologien (wie z.B. Sol-Gel-Verfahren) ist ein Tempern des Substrates vor oder nach der Beschichtung nicht notwendig, um die Schicht homogen und haftfest auf größeren Flächen abzuscheiden. Darüber hinaus entfallen die bei nasschemischen Verfahren anzuwendenden Regelungen in Bezug auf emittierende Lösungsmittel oder flüssige Abfälle.

Es kann ein Precursor verwendet werden, der Silizium oder eine Siliziumverbindung umfasst während ein anderer der Precursoren Phosphor oder eine Phosphorverbindung umfasst.

Alternativ kann Silizium oder eine Siliziumverbindung und Phosphor oder eine Phosphorverbindung in ein und demselben Precursor enthalten sein, so dass nur ein Precursor benötigt wird.

Die Abscheidung der Schicht findet bei Atmosphärendruck (auch Normaldruck genannt) statt. Normaldruckplasmaverfahren erfordern einen wesentlich geringeren technischen Aufwand, da eine Behandlung der zu beschichtenden Oberfläche im Vakuum entfällt. Beim Normaldruckplasmaverfahren bilden sich die Partikel im Plasmastrom. Die Größe der Agglomerate aus diesen Partikeln und somit wesentliche Eigenschaften der Beschichtung lassen sich unter anderem durch den Abstand der Plasmaquelle von der Oberfläche einstellen. Die Homogenität der abgeschiedenen Schichten ist mit den durch Beflammung erzielten vergleichbar, der erforderliche Energieeintrag ist jedoch wesentlich geringer. Alternativ kann das Verfahren auch bei leicht reduziertem Normaldruck durchgeführt werden.

Durch die Abscheidung unter Atmosphärenbedingungen entfallen sowohl die Kosten für die Vakuumerzeugung als auch ein Teil der Energiekosten für den Plasmaprozess, da der Energieeinsatz bei der Plasmabeschichtung von Oxiden wesentlich höher ist als bei Metallabscheidungen. Das Verfahren ist mit einer vergleichsweise einfachen und dementsprechend kostengünstigen Anlagentechnik realisierbar.

In einer weiteren bevorzugten Ausführungsform enthält mindestens einer der Precursoren mindestens einen der Stoffe Chrom, Vanadin, Wolfram und Molybdän oder mindestens eine Verbindung mindestens eines dieser Stoffe.

Mit dem Verfahren können beispielsweise Substrate aus einem der Stoffe Glas, Kunststoff, Glaskeramik, Keramik und Metall beschichtet werden.

Wird der Precursor einem Arbeitsgas oder einem Plasmastrom zugesetzt, so kann die Erzeugung des Plasmas vorzugsweise in einer Freistrahlplasmaquelle oder durch dielektrisch behinderte Entladung oder durch eine Mikrowellenanregung erfolgen.

Die Erzeugung des Plasmas kann in einer Freistrahlplasmaquelle erfolgen. Bei diesem Verfahren wird eine Hochfrequenzentladung zwischen zwei konzentrischen Elektroden gezündet, wobei durch einen angelegten Gasstrom das sich bildende Hohlkathodenplasma als Plasmajet aus der Elektrodenanordnung in aller Regel mehrere Zentimeter in den freien Raum und zur zu beschichtenden Oberfläche herausgeführt wird. Der Precursor kann sowohl vor der Anregung in das Arbeitsgas (direct plasma processing) als auch danach in das bereits gebildete Plasma oder in dessen Nähe (remote plasma processing) eingeleitet werden.

Eine weitere Möglichkeit der Plasmaerzeugung ist das Ausnutzen einer dielektrisch behinderten Entladung. Dabei wird das als Dielektrikum dienende Arbeitsgas, insbesondere Luft, zwischen zwei Elektroden hindurchgeleitet. Die Plasmaentladung erfolgt zwischen den Elektroden, welche mit hochfrequenter Hochspannung gespeist werden. Ebenso kann das Substrat selbst als Dielektrikum genutzt werden, indem der Gasstrom zwischen einer metallischen Flächenelektrode und dem flachen Substrat hindurch geführt wird.

Der Precursor wird vorzugsweise im gasförmigen Zustand in das Arbeitsgas oder den Plasmastrom oder die Flamme eingeleitet. Flüssige oder feste, insbesondere pulverförmige Precursoren sind ebenfalls einsetzbar, werden jedoch bevorzugt vor der Einleitung, beispielsweise durch Verdampfung, in den gasförmigen Zustand überführt. Ebenso kann der Precursor zunächst in ein Trägergas eingeleitet, davon mitgerissen und zusammen mit diesem in das Arbeitsgas oder den Plasmastrom oder die Flamme eingeleitet werden.

Der Durchsatz des Arbeitsgases und/oder des Precursors ist vorzugsweise variabel und steuerbar und/oder regelbar. Insbesondere sind die Durchsätze von Arbeitsgas und Precursor unabhängig voneinander steuerbar und/oder regelbar. Neben dem Abstand der Plasmaquelle bzw. des Brenners zu der zu beschichtenden Oberfläche steht so ein weiteres Mittel zur Beeinflussung der Schichteigenschaften, wie beispielsweise der Schichtdicke oder der Brechzahl, zur Verfügung. Ebenso sind auf diese Weise Gradientenschichten realisierbar. Insbesondere ist der Durchsatz der beiden Precursoren relativ zueinander bzw. das Verhältnis von Silizium und Phosphor im Precursor einstellbar.

Durch geeignete Wahl dieser Prozessparameter und der verwendeten Precursoren sind beispielsweise folgende Eigenschaften des Substrats gezielt veränderbar: Kratzfestigkeit, Selbstheilungsfähigkeit, Barriereverhalten, Reflexionsverhalten, Transmissionsverhalten, Brechungsindex, Transparenz, Lichtstreuung, elektrische Leitfähigkeit, antibakterielles Verhalten, Reibung, Haftung, Hydrophilie, Hydrophobie, Oleophobie, Oberflächenspannung, Oberflächenenergie, antikorrosive Wirkung, schmutzabweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, elektrostatisches Verhalten, elektrochrome Aktivität, photochrome Aktivität, gasochrome Aktivität.

Als Arbeitsgas können Luft oder ein Gas verwendet werden. Hierfür kommen beispielsweise Sauerstoff, Stickstoff, Edelgase, Wasserstoff, Kohlendioxid, gasförmige Kohlenwasserstoffe oder eine Mischung wenigstens zweien der vorgenannten Arbeitsgase in Frage.

Vorzugsweise wird das Substrat bei einer Temperatur von 40°C bis 1000°C beschichtet.

Die Beschichtung erfolgt bevorzugt mit einem Winkel zwischen dem Substrat und einem Brenner oder einer Plasmadüse in einem Bereich zwischen 0° und 90°.

Ein Ausführungsbeispiel der Erfindung wird im Folgenden anhand einer Zeichnung näher erläutert.

Darin zeigt:

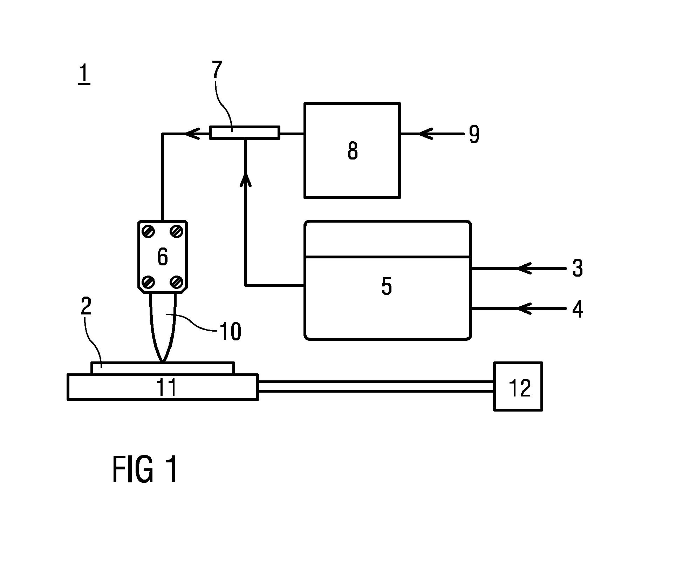

- Figur 1: einen schematischen Aufbau einer Vorrichtung zur Durchführung eines Verfahrens zum Beschichten eines Substrats

**In** **Figur 1** ist schematischer Aufbau einer Vorrichtung 1 zur Durchführung eines Verfahrens zum Beschichten eines Substrats 2 gezeigt. Die Vorrichtung 1 kann zur flammenpyrolytischen Abscheidung von Schichten auf dem Substrats 2 verwendet werden. Dabei wird ein Brenngas 3 (beispielsweise Propan) und ein Oxidationsmittel 4 (beispielsweise Luft) in einer Mischkammer 5 in einem ausgewählten Mischungsverhältnis zur Bildung eines Brenngasgemischs zusammengeführt. Auf dem Weg zu einem Brenner 6 wird in einem Mischsystem 7 mittels einer Pecursordosiereinrichtung 8 ein Precursor 9 (beispielsweise eine Lösung von Trimethylsilylphosphat in Ethanol) in das Brenngasgemisch injiziert. Das dabei entstehende Gemisch wird durch den Brenner 6 geführt und an dessen Austrittsöffnungen verbrannt. Dies führt zur Bildung einer Flamme 10, die oxidierte Zersetzungsprodukte des Precursors 9 enthält. Diese werden bei geeigneter Parameterwahl haftfest auf dem Substrat 2 abgeschieden, welches sich auf einem temperierten Substrathalter 11 befindet, der eine Horizontalbewegung unterhalb des Brenners 6 ausführt. Alternativ ist es möglich, den temperierten Substrathalter 11 in seiner Position zu fixieren und den Brenner 6 relativ zum Substrat 2 zu bewegen. Die Substrattemperierung 12 erfolgt beispielsweise elektrisch.

Mittels eines Propan/Luftbrenners wurde bei einer Leistung von 12,5 kW/h, einem Luft/Gasverhältnis von 24:1, einem Brenner/Substrat Abstand von 10 mm, einer Verfahrgeschwindigkeit von 30 mm/s, einer Wartezeit zwischen den Beschichtungszyklen von 50 Sekunden, einem Precursorfluss von 1,1 ml/min binnen 10 Beschichtungszyklen eine ca. 150-170 nm dicke Silizium und Phosphor enthaltende Schicht (XPS-Daten) auf Stahl DC 04 abgeschieden. Als Precursor wurde eine 10%-ige Lösung von Trimethylsilylphosphat in Ethanol genutzt. Das so beschichtete Substrat 2 wurde einem Korrosionstest (Salzsprühtest) unterzogen und zeigte selbst nach 55 h Belastung keinerlei Rostspuren, während das unbeschichtete Material nach 1 h bereits stark korrodiert war.

Alternativ zum Brenner 6 kann eine Plasmadüse verwendet werden. Statt der Flamme 10 entsteht dann eine Plasmafackel.

Bei Verwendung einer Plasmadüse wird der Precursor 9 einem Arbeitsgas und/oder einem Plasmastrahl statt dem Brenngasgemisch zugeführt.

Eine Zuführung des Precursors 9 kann alternativ auch direkt in die Flamme 10 erfolgen.

Es können mehrere Precursoren 9 vorgesehen sein, von denen einer Silizium und einer Phosphor enthält. Ebenso können Silizium und Phosphor in ein und dem selben Precursor 9 enthalten sein.
Die Abscheidung der Schicht findet bei Atmosphärendruck (auch Normaldruck genannt) statt.

In einer weiteren bevorzugten Ausführungsform enthält mindestens einer der Precursoren 9 mindestens einen der Stoffe Chrom, Vanadin, Wolfram und Molybdän oder mindestens eine Verbindung mindestens eines dieser Stoffe.

Mit dem Verfahren können beispielsweise Substrate 2 aus einem der Stoffe Glas, Kunststoff, Glaskeramik, Keramik und Metall beschichtet werden.

Erfindungsgemäß wird ein eisenhaltiges Substrat beschichtet.

Wird der Precursor 9 einem Arbeitsgas oder einem Plasmastrom zugesetzt, so kann die Erzeugung des Plasmas vorzugsweise in einer Freistrahlplasmaquelle oder durch dielektrisch behinderte Entladung oder durch eine Mikrowellenanregung erfolgen.

Der Precursor 9 wird vorzugsweise im gasförmigen Zustand in das Arbeitsgas oder den Plasmastrom oder die Flamme 10 eingeleitet. Flüssige oder feste, insbesondere pulverförmige Precursoren 9 sind ebenfalls einsetzbar, werden jedoch bevorzugt vor der Einleitung, beispielsweise durch Verdampfung, in den gasförmigen Zustand überführt. Ebenso kann der Precursor 9 zunächst in ein Trägergas eingeleitet, davon mitgerissen und zusammen mit diesem in das Arbeitsgas oder den Plasmastrom oder die Flamme 10 eingeleitet werden.

Der Durchsatz des Arbeitsgases und/oder des Precursors 9 ist vorzugsweise variabel und steuerbar und/oder regelbar. Insbesondere sind die Durchsätze von Arbeitsgas und Precursor 9 unabhängig voneinander steuerbar und/oder regelbar. Insbesondere ist der Durchsatz der beiden Precursoren 9 relativ zueinander bzw. das Verhältnis von Silizium und Phosphor im Precursor 9 einstellbar. Die Schicht kann in Form einer Gradientenschicht abgeschieden werden.

Durch geeignete Wahl dieser Prozessparameter und der verwendeten Precursoren 9 sind beispielsweise folgende Eigenschaften des Substrats 2 gezielt veränderbar: Kratzfestigkeit, Selbstheilungsfähigkeit, Barriereverhalten, Reflexionsverhalten, Transmissionsverhalten, Brechungsindex, Transparenz, Lichtstreuung, elektrische Leitfähigkeit, antibakterielles Verhalten, Reibung, Haftung, Hydrophilie, Hydrophobie, Oleophobie, Oberflächenspannung, Oberflächenenergie, antikorrosive Wirkung, schmutzabweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, elektrostatisches Verhalten, elektrochrome Aktivität, photochrome Aktivität, gasochrome Aktivität.

Als Arbeitsgas für die Plasmaerzeugung können Luft oder ein Gas oder Dampf verwendet werden. Hierfür kommen beispielsweise Sauerstoff, Stickstoff, Edelgase, Wasserstoff, Kohlendioxid, gasförmige Kohlenwasserstoffe oder eine Mischung wenigstens zweien der vorgenannten Arbeitsgase in Frage.

Vorzugsweise wird das Substrat 2 bei einer Temperatur von 40°C bis 1000°C beschichtet.

Die Beschichtung erfolgt bevorzugt mit einem Winkel zwischen dem Substrat 2 und dem Brenner 6 oder einer Plasmadüse in einem Bereich zwischen 0° und 90°.

### BEZUGSZEICHENLISTE

- 1: Vorrichtung
- 2: Substrat
- 3: Brenngas
- 4: Oxidationsmittel
- 5: Mischkammer
- 6: Brenner oder Plasmadüse
- 7: Mischsystem
- 8: Precursordosiereinrichtung
- 9: Precursor
- 10: Flamme oder Plasmafackel
- 11: Substrathalter
- 12: Substrattemperierung

## Patentansprüche

1. Verwendung einer Schicht auf einer Oberfläche eines eisenhaltigen Substrats (2), wobei die Schicht hergestellt ist nach einem Verfahren zur Beschichtung des Substrats (2), bei dem mindestens ein Precursor (9) einem Arbeitsgas und/oder einem Plasmastrahl und/oder einer Flamme (10) zugeführt und im Plasmastrahl oder in der Flamme (10) zur Reaktion gebracht wird, wobei einer der Precursoren (9) Silizium oder eine Siliziumverbindung umfasst, wobei einer der Precursoren (9) Phosphor oder eine Phosphorverbindung umfasst, wobei eine Mischschicht mit einem ternären System, das Phosphor, Silizium und Sauerstoff enthält auf der Oberfläche des Substrats (2) bei Atmosphärendruck abgeschieden wird, zum Korrosionsschutz des Substrats (2).

2. Verwendung nach Anspruch 1, **dadurch gekennzeichnet, dass** einer der Precursoren (9) Silizium oder eine Siliziumverbindung umfasst und dass ein anderer der Precursoren (9) Phosphor oder eine Phosphorverbindung umfasst.

3. Verwendung nach Anspruch 1, **dadurch gekennzeichnet, dass** einer der Presursoren (9) Silizium oder eine Siliziumverbindung und Phosphor oder eine Phosphorverbindung umfasst.

4. Verwendung nach einem der vorhergehenden Ansprüche, **dadurch gekennzeichnet, dass** mindestens einer der Precursoren (9) mindestens einen der Stoffe Chrom, Vanadin, Wolfram und Molybdän oder mindestens eine Verbindung mindestens eines dieser Stoffe enthält.

5. Verwendung nach einem der vorhergehenden Ansprüche, **dadurch gekennzeichnet, dass** die Erzeugung des Plasmas in einer Freistrahlplasmaquelle oder durch dielektrisch behinderte Entladung oder durch eine Mikrowellenanregung erfolgt.

6. Verwendung nach einem der vorhergehenden Ansprüche, **dadurch gekennzeichnet, dass** ein gasförmiger Precursor (9) verwendet wird.

7. Verwendung nach einem der vorhergehenden Ansprüche, **dadurch gekennzeichnet, dass** mittels mindestens einer der abgeschiedenen Schichten mindestens eine der Eigenschaften des Substrats (2) Kratzfestigkeit, Selbstheilungsfähigkeit, Barriereverhalten, Reflexionsverhalten, Transmissionsverhalten, Brechungsindex, Transparenz, Lichtstreuung, elektrische Leitfähigkeit, antibakterielles Verhalten, Reibung, Haftung, Hydrophilie, Hydrophobie, Oleophobie, Oberflächenspannung, Oberflächenenergie, antikorrosive Wirkung, schmutzabweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, elektrostatisches Verhalten, elektrochrome Aktivität, photochrome Aktivität, und gasochrome Aktivität verändert wird.

8. Verwendung nach einem der vorhergehenden Ansprüche, **dadurch gekennzeichnet, dass** als Arbeitsgas Sauerstoff, Stickstoff, Edelgase, Wasserstoff, Kohlendioxid, gasförmige Kohlenwasserstoffe oder eine Mischung wenigstens zweien der vorgenannten Arbeitsgase verwendet wird.

9. Verwendung nach Anspruch 8, **dadurch gekennzeichnet, dass** als Arbeitsgas Luft verwendet wird.

10. Verwendung nach einem der vorhergehenden Ansprüche, **dadurch gekennzeichnet, dass** mindestens eine der Schichten als Gradientenschicht abgeschieden wird.

11. Verwendung nach einem der vorhergehenden Ansprüche, **dadurch gekennzeichnet, dass** ein Durchsatz des Arbeitsgases und/oder des Precursors (9) variabel und steuerbar und/oder regelbar ist.

12. Verwendung nach einem der vorhergehenden Ansprüche, **dadurch gekennzeichnet, dass** das Substrat (2) bei einer Temperatur von 40°C bis 1000°C beschichtet wird.

13. Verwendung nach einem der vorhergehenden Ansprüche, **dadurch gekennzeichnet, dass** die Beschichtung mit einem Winkel zwischen dem Substrat (2) und einem Brenner (6) oder einer Plasmadüse in einem Bereich zwischen 0° und 90° durchgeführt wird.

## Claims

1. Use of a layer on a surface of an iron-containing substrate (2), wherein the layer is produced by a process for coating the substrate (2) in which at least one precursor (9) is supplied to a working gas and/or to a plasma jet and/or to a flame (10) and reacted in the plasma jet or in the flame (10), wherein one of the precursors (9) comprises silicon or a silicon compound, wherein one of the precursors (9) comprises phosphorus or a phosphorus compound, and wherein a mixed layer with a ternary system containing phosphorus, silicon and oxygen is deposited on the surface of the substrate (2) at atmospheric pressure for protecting the substrate (2) against corrosion.

2. Use according to Claim 1, **characterized in that** one of the precursors (9) comprises silicon or a silicon compound and **in that** another of the precursors (9) comprises phosphorus or a phosphorus compound.

3. Use according to Claim 1, **characterized in that** one of the precursors (9) comprises silicon or a silicon compound and phosphorus or a phosphorus compound.

4. Use according to one of the preceding claims, **characterized in that** at least one of the precursors (9) contains at least one of the materials chromium, vanadium, tungsten and molybdenum or at least one compound of at least one of these materials.

5. Use according to one of the preceding claims, **characterized in that** the plasma is produced in a free jet plasma source or by dielectrically hindered discharge or by microwave excitation.

6. Use according to one of the preceding claims, **characterized in that** a gaseous precursor (9) is used.

7. Use according to one of the preceding claims, **characterized in that** at least one of the deposited layers is used to modify at least one of the following properties of the substrate (2): scratch resistance, self-healability, barrier behaviour, reflection behaviour, transmission behaviour, refractive index, transparency, light scattering, electrical conductivity, antibacterial behaviour, friction, adhesion, hydrophilicity, hydrophobicity, oleophobicity, surface tension, surface energy, anticorrosive effect, dirt-repellent action, self-cleanability, photocatalytic behaviour, anti-stress behaviour, wear behaviour, chemical resistance, biocidal behaviour, biocompatible behaviour, electrostatic behaviour, electrochromic activity, photochromic activity and gasochromic activity.

8. Use according to one of the preceding claims, **characterized in that** the working gas used is oxygen, nitrogen, noble gases, hydrogen, carbon dioxide, gaseous hydrocarbons or a mixture of at least two of the aforementioned working gases.

9. Use according to Claim 8, **characterized in that** the working gas used is air.

10. Use according to one of the preceding claims, **characterized in that** at least one of the layers is deposited as a gradient layer.

11. Use according to one of the preceding claims, **characterized in that** a throughput of the working gas and/or of the precursor (9) is variable and can be controlled and/or regulated.

12. Use according to one of the preceding claims, **characterized in that** the substrate (2) is coated at a temperature of 40°C to 1000°C.

13. Use according to one of the preceding claims, **characterized in that** the coating is carried out with an angle in a range of between 0° and 90° between the substrate (2) and a torch (6) or a plasma nozzle.

## Revendications

1. Utilisation d'une couche sur une surface d'un substrat contenant du fer (2), la couche ayant été produite par un procédé pour le revêtement du substrat (2), dans lequel on ajoute au moins un précurseur (9) à un gaz de travail et/ou à un faisceau de plasma et/ou à une flamme (10) et on le fait réagir dans le faisceau de plasma et/ou dans la flamme (10), dans lequel un des précurseurs (9) comprend du silicium ou un composé du silicium, dans lequel un des précurseurs (9) comprend du phosphore ou un composé du phosphore, dans lequel on dépose une couche mixte, présentant un système ternaire qui contient du phosphore, du silicium et de l'oxygène, sur la surface du substrat (2) à la pression atmosphérique, pour la protection du substrat (2) contre la corrosion.

2. Utilisation selon la revendication 1, **caractérisée en ce qu'**un des précurseurs (9) comprend du silicium ou un composé du silicium et **en ce qu'**un autre des précurseurs (9) comprend du phosphore ou un composé du phosphore.

3. Utilisation selon la revendication 1, **caractérisée en ce qu'**un des précurseurs (9) comprend du silicium ou un composé du silicium et du phosphore ou un composé du phosphore.

4. Utilisation selon l'une quelconque des revendications précédentes, **caractérisée en ce qu'**au moins un des précurseurs (9) contient au moins une des substances chrome, vanadium, tungstène et molybdène ou au moins un composé d'au moins une de ces substances.

5. Utilisation selon l'une quelconque des revendications précédentes, **caractérisée en ce que** la production du plasma est effectuée dans une source de plasma à jet libre ou par une décharge empêchée par diélectrique ou par une excitation aux micro-ondes.

6. Utilisation selon l'une quelconque des revendications précédentes, **caractérisée en ce que** l'on utilise un précurseur gazeux (9).

7. Utilisation selon l'une quelconque des revendications précédentes, **caractérisée en ce que** l'on modifie, au moyen d'au moins une des couches déposées, au moins une des propriétés du substrat (2), résistance à l'abrasion, pouvoir d'autoguérison, comportement de barrière, comportement de réflexion, comportement de transmission, indice de réfraction, transparence, dispersion de la lumière, conductibilité électrique, comportement antibactérien, friction, adhérence, hydrophilie, hydrophobie, oléophobie, tension superficielle, énergie superficielle, action anticorrosion, action anti-salissures, capacité d'auto-nettoyage, comportement photocatalytique, comportement anti-stress, comportement d'usure, capacité de résistance chimique, comportement biocide, comportement biocompatible, comportement électrostatique, activité électrochrome, activité photochrome, et activité gazochrome.

8. Utilisation selon l'une quelconque des revendications précédentes, **caractérisée en ce que** l'on utilise comme gaz de travail l'oxygène, l'azote, des gaz rares, l'hydrogène, le dioxyde de carbone, des hydrocarbures gazeux ou un mélange d'au moins deux des gaz de travail précités.

9. Utilisation selon la revendication 8, **caractérisée en ce que** l'on utilise l'air comme gaz de travail.

10. Utilisation selon l'une quelconque des revendications précédentes, **caractérisée en ce que** l'on dépose au moins une des couches sous la forme d'une couche en gradient.

11. Utilisation selon l'une quelconque des revendications précédentes, **caractérisée en ce qu'**un débit du gaz de travail et/ou du précurseur (9) est variable et peut être commandé et/ou régulé.

12. Utilisation selon l'une quelconque des revendications précédentes, **caractérisée en ce que** l'on revêt le substrat (2) à une température de 40°C à 1000°C.

13. Utilisation selon l'une quelconque des revendications précédentes, **caractérisée en ce que** l'on effectue le revêtement avec un angle entre le substrat (2) et un brûleur (6) ou une buse à plasma dans une plage comprise entre 0° et 90°.
